# EUROPEAN PATENT APPLICATION

(11) **EP 2 131 642 A1**
(43) Date of publication of application: **09.12.2009**
(21) Application number: 08722916.7
(22) Date of filing: 27.03.2008
(51) Int. Cl.: H05K 9/00, B32B 7/02

(54) **ELECTROMAGNETIC SHIELD SHEET AND RFID PLATE**

(30) Priority: 29.03.2007 JP 2007087118
(71) Applicant: Kabushiki Kaisha Asahi Rubber, Saitama 330-0801 (JP); Kabushiki Kaisha Fine Rubber Kenkyuusho, Saitama-shi, Saitama 3300801 (JP)
(72) Inventor: NAKAMURA, Munetomo, Saitama-shi Saitama 330-0801 (JP); KOYAMASHITA, Yuji, Saitama-shi Saitama 330-0801 (JP)
(74) Representative: Naylor, Matthew John
(86) International application number: PCT/JP2008/055877
(87) International publication number: WO 2008/126690

(57) **Abstract**

Provided is an electromagnetic shield sheet having an excellent electromagnetic shielding effect which can be sufficiently exhibited even when the sheet has a reduced thickness and a reduced weight. Furthermore, the electromagnetic shield sheet has an excellent molding efficiency and flexibility and can be used in a desired shape such as various shapes of a power supply box, an inner wall, or an electronic device for electromagnetic shielding. An RFID plate using the electromagnetic shield sheet is also provided. The electromagnetic shield sheet A has a polymer composition layer obtained by mixing a conductive material with a polymer material. The sheet A is formed by layering at least two of polymer composition layers 1, 2, 3 having different dielectric constants. The RFID plate is formed by layering the electromagnetic shield sheet A, an IC, and an antenna circuit.

## Description

### Technical Field

The present invention relates to an electromagnetic shield sheet which can shield electromagnetic waves propagated toward an electronic apparatus from external environments or electromagnetic waves leaking from the inside of an electronic apparatus or can shield electromagnetic waves with respect to only a space spreading in some direction(s). More particularly, the invention relates to an electromagnetic shield sheet having an excellent electromagnetic shielding effect which can be sufficiently exhibited even when the sheet has a reduced thickness and a reduced weight. In addition, the invention relates to an electromagnetic shield sheet which can cope with a variety of shapes and which also allows addition of heat resistance, dimensional stability, and radiating properties in relation to heat. The invention relates to an electromagnetic shield sheet which, when obtained by layering at least two polymer composition layers having different dielectric constants, can prevent electronic elements arranged in an electronic circuit board from being put into malfunction due to externally coming electromagnetic waves, or can achieve electromagnetic shielding in some spatial direction(s) so that signals or noises generated by an electronic circuit responding to or being influenced by externally coming electromagnetic waves will not exert influences on some space. Besides, the invention relates to an electromagnetic shield sheet which also can close electromagnetic wave generating sources to perfectly inhibit propagation of electromagnetic waves so that component parts liable to generate electromagnetic waves, such as a power switch and a transformer, would not impose electromagnetic interference on circuit elements in an electronic apparatus and, further, that electronic elements in the same board circuit would not impose electromagnetic interference on each other.

Furthermore, the present invention relates to provision of a useful RFID (Radio Frequency Identification) plate with electronic parts incorporated therein which is obtained by combining the above-mentioned electromagnetic shield sheet with an electronic circuit, as a card, tag, label or the like which would not influence electronic circuit boards controlled in regard of propagation of electromagnetic waves and not influence human bodies or which cannot be externally read unguardedly.

### Background Art

While on one hand the convenience on a living basis is enhanced by the progress of electronic technologies, on the other hand troubles of failure of electronic circuits in use are generated due to influences of electromagnetic waves coming from the outside or the inside of an apparatus. For instance, in an electronic circuit board, electromagnetic interference occurs between a reactance circuit on the circuit board and an adjacent semiconductor device or the like. If this causes a malfunction or halt of a circuit to make an electronic controller's control impossible, a tremendous loss on an industrial basis would result. In the case of a common consumer, also, such a trouble makes it impossible for the consumer to use the electronic apparatus without anxiety. Therefore, an improvement of this problem is keenly demanded by the relevant industries.

There have already been proposed several methods for shielding electromagnetic interference. For example, metal-based and ceramic-based electromagnetic shielding materials have been known. However, these shielding materials are insufficient in performance and have shortcomings as to weight (mass) and production cost. Thus, an electromagnetic shielding material which is light in weight, inexpensive, and sufficient in properties demanded industrially has not been present or put to satisfactory use. The methods for electromagnetic shielding are generally classified into two types: one in which electromagnetic waves are reflected to thereby protect an apparatus such as an internal electronic circuit, and one in which electromagnetic waves are absorbed so as to protect an apparatus such as an internal electronic circuit. In addition, considering the relationship between an electromagnetic wave generating source and an object to be protected, the shielding effect of an electromagnetic sheet varies depending on the frequency of the electromagnetic wave in consideration, the distance between the electromagnetic wave generating source and the object and, further, the distances between each of them and the electromagnetic shield sheet arranged. Thus, a satisfactory electromagnetic shielding sheet (electromagnetic shield sheet) cannot easily be supplied at present.

As a conventionally known technology, for example, Patent Document 1 discloses, as a flexible material, a conductive rubber composition containing a crosslinked granular polymer (A1), an uncrosslinked polymer (A2), and an electrically conducting agent (B), wherein the electrically conducting agent (B) is unevenly distributed in the uncrosslinked polymer (A2), and a crosslinked product obtained by subjecting the composition to crosslinking has an electromagnetic absorbing power of not less than 25 dB. Depending on the mode of use, however, the conductive rubber composition has not necessarily provided a sufficient effect efficiently in precision circuits or the like, due to diffraction of electromagnetic waves or the like.
Patent Document 1: Japanese Patent Laid-Open No. 2002-309107

In addition, for example, Patent Document 2 discloses an electromagnetic shielding sheet for shielding electromagnetic waves radiated from various electronic apparatuses such as TVs and personal computers, obtained by loading a matrix resin with a ceramic fine powder having an ion generating power and a magnetic powder. In this technology, however, the shielding effect is obtained by absorbing the electromagnetic waves coming from the generating source and, therefore, there is a problem in that the sheet generates heat upon absorption of energy, so that the resulting deformation or the like leads to a change in the shielding effect, and the shielding sheet cannot be used stably. In addition, since a large amount of ceramic is used, an increase in weight results, which is disadvantageous from the viewpoint of convenience for portable electronic apparatuses. Patent Document 2: Japanese Patent Laid-Open No. 2002-43792

Further, for example, Patent Document 3 discloses a laminate-type electromagnetic absorber in which a plurality of laminate component materials differing in impedance (Z) are so layered that the impedance (Z) is gradually decreased from the electromagnetic wave incidence side along the transmission direction of the wave. Specifically, a laminate-type electromagnetic absorber is disclosed in which a plurality of laminate component materials made different in impedance (Z), magnetic permeability (µ) or dielectric constant (e) by varying contents of a spherical magnetic powder and a flat magnetic powder are layered. Such an absorber, however, not only has an increased weight but also has the problem that the particles of the spherical magnetic powder contained therein are large. Specifically, it is described that the spherical magnetic powder has a maximum average particle diameter of 100 µm, and the spherical magnetic powder used in Example has an average particle diameter of 20 µm. Therefore, use of the spherical magnetic powder alone would lead to nonuniformity of dispersion. The influence of the nonuniform dispersion becomes more conspicuous as the layers constituting the laminate become thinner. Patent Document 3: Japanese Patent Laid-Open No. 2000-31686

Furthermore, there has not been an electromagnetic shield sheet which, when used in a circuit designed to receive an externally coming electromagnetic wave signal and to respond in the form of a signal, shows a directional property, such as ability to transmit a signal not omnidirectionally but unidirectionally or ability to transmit a signal by receiving an electromagnetic wave signal coming from a predetermined direction, is efficient, has security, is assuredly safe for human bodies, is deformable, and can provide a sufficient electromagnetic shielding effect. Realization of such an electromagnetic shield sheet has been demanded in various industrial fields.

### Disclosure of Invention

### Problems to be Solved by the Invention

The present invention has been made in order to solve the above-mentioned problems. Accordingly, it is an object of the present invention to provide an electromagnetic shield sheet which has an excellent electromagnetic shielding effect capable of being sufficiently exhibited even upon reductions in the thickness and weight of the sheet, which enables additional provision of excellent formability (moldability) and flexibility, which enables selection of the shielding direction, and which can be used in a desired shape such as various shapes of a power supply box, an inner wall, a space, or an electronic apparatus for electromagnetic shielding. It is another object of the present invention to provide an electromagnetic shield sheet which can be favorably used, for instance, for electronic circuit board use to prevent an electronic component part in an electronic circuit board from imposing electromagnetic interference on neighboring electronic component parts on the same board due to electromagnetic waves generated from itself, and which can stably maintain an electromagnetic shielding effect. It is a further object of the present invention to provide an electromagnetic shield sheet which can shield electromagnetic waves generated from various electronic apparatuses such as TVs, personal computers, mobile phones, etc. in order to prevent not only circuit boards but also power switches, motors or the like, possibly generating strong electromagnetic waves through electric discharge, from imposing electromagnetic interference on other electronic apparatuses, and which can also prevent the various electronic apparatuses from suffering external electromagnetic interference.

Furthermore, it is yet another object of the present invention to provide an RFID (Radio Frequency Identification) plate capable of being suitably used as an IC tag, a label, a readable card, a name plate or the like which is high in efficiency, security, and safety for human bodies, when combined with an integrated circuit (hereinafter referred to also as "IC") and/or an antenna circuit so as, for example, to select the shielding direction in relation to the transmission from the antenna circuit or to enable reception of only signals coming from a fixed direction by performing electromagnetic shielding in the opposite direction, according to the intended use.

### Means for Solving the problems

The present inventors ardently made investigations in order to attain the above objects, and, as a result of their investigations, they found out the following. In the case of electromagnetic shield sheets in which a polymer material and a conductive material are used in such a manner that the total loading of the conductive material based on the polymer material is the same or comparable and that the sheet thickness is the same, when a monolayer-type electromagnetic shield sheet composed of a polymer composition layer in which the compounding ratio of the conductive material is uniform (or a laminate-type electromagnetic shield sheet obtained by layering a plurality of polymer composition layers equal in loading of the conductive material and equal in dielectric constant so as to obtain the above-mentioned sheet thickness) and a laminate-type electromagnetic shield sheet in which a plurality of polymer composition layers different in loading of the conductive material and different in dielectric constant are layered so as to obtain the above-mentioned total loading and the above-mentioned sheet thickness, are compared with each other in the shielding effect on electromagnetic waves coming from an electromagnetic wave generating source, it was surprisingly found that the laminate-type electromagnetic shield sheet is much superior to the monolayer-type electromagnetic shield sheet in electromagnetic shielding effect. Based on the finding, the present invention has been completed.

According to the present invention, there is provided an electromagnetic shield sheet having a polymer composition layer obtained by mixing a conductive material with a polymer material, the sheet formed by layering at least two of the polymer composition layers having different dielectric constants. Here, the electromagnetic shield sheet according to the invention, preferably, contains carbon nanotube as the conductive material. In addition, in the electromagnetic shield sheet of the invention, preferably, the polymer material is an elastomer, and, more preferably, the polymer material is a silicone rubber.

Further, in the electromagnetic shield sheet according to the present invention, preferably, an insulating polymer layer is layered on the polymer composition layers, and, more preferably, the insulating polymer layer contains a magnetic material powder. In the case of layering the insulating polymer layer, the insulating polymer layer may well be layered on the side of the polymer composition layer having a lower dielectric constant, of the polymer composition layers. In addition, it is preferable for the electromagnetic shield sheet of the invention to have a pressure sensitive adhesive surface, since the use of the sheet is thereby widened. It is more preferable for the electromagnetic shield sheet of the invention to be an electromagnetic shield sheet in which the insulating polymer layer is layered and the insulating polymer layer has a pressure sensitive adhesive surface. Further, the electromagnetic shield sheet of the invention, preferably, includes at least three of the polymer composition layers which are so layered that dielectric constant is increased sequentially. Also, in the electromagnetic shield sheet of the invention, preferably, at least three of the polymer composition layers different in mixing ratio of the conductive material to the polymer material are provided as the polymer composition layers having different dielectric constants, and the at least three polymer composition layers are so layered that the mixing ratio of the conductive material is increased sequentially. Moreover, the electromagnetic shield sheet of the invention, preferably, is so used that one of the polymer composition layers which is the lowest of the polymer composition layers in dielectric constant is nearer to an electromagnetic wave generating source, or the sheet is so used that one of the polymer composition layers which is the lowest of the polymer composition layers in the mixing ratio of the conductive material is nearer to an electromagnetic wave generating source.

Besides, according to the present invention, there is provided an RFID plate including a laminate obtained by layering the above-mentioned electromagnetic shield sheet as well as an integrated circuit and/or an antenna circuit. Specifically, according to the invention, there is provided an RFID plate including a laminate obtained by layering the electromagnetic shield sheet and an IC, a laminate obtained by layering the electromagnetic shield sheet and an antenna circuit, or a laminate obtained by layering the electromagnetic shield sheet as well as an IC and an antenna circuit. The RFID plate is high in handleability and efficiency, and is useful. When the RFID plate of the invention is a card, a tag, or a label, in other words, when the laminate of the invention is provided in a card, a tag, or a label, or when the RFID plate of the invention is configured as a card, a tag, or a label, the RFID (Radio Frequency Identification) plate of the invention can be used as a card, a tag, or a label, in a particularly useful manner.

### Effects of the Invention

According to the present invention, even in the cases of electromagnetic shield sheets being the same or comparable in the loading ratio of the conductive material to the polymer material, an electromagnetic shield sheet showing a much higher electromagnetic shielding effect than those of conventional electromagnetic shield sheets can be obtained. Therefore, the electromagnetic shield sheet according to the present invention has a shielding effect which can be sufficiently exhibited even when the sheet has a reduced thickness and a reduced weight. Further, the electromagnetic shield sheet of the invention allows additional provision of excellent formability (moldability) and flexibility, so that the sheet can be used in electronic apparatuses of various shapes for electromagnetic shielding. In addition, since the electromagnetic shield sheet has a high shielding effect and a high reflection efficiency, an efficient RFID (Radio Frequency Identification) plate can be realized by laminating the sheet with an antenna circuit, such as a printed antenna circuit, or an IC (Integrated Circuit) with an antenna which is operative to process signals for transmission/reception of an electromagnetic wave.

### Brief Description of Drawings

[FIG. 1]

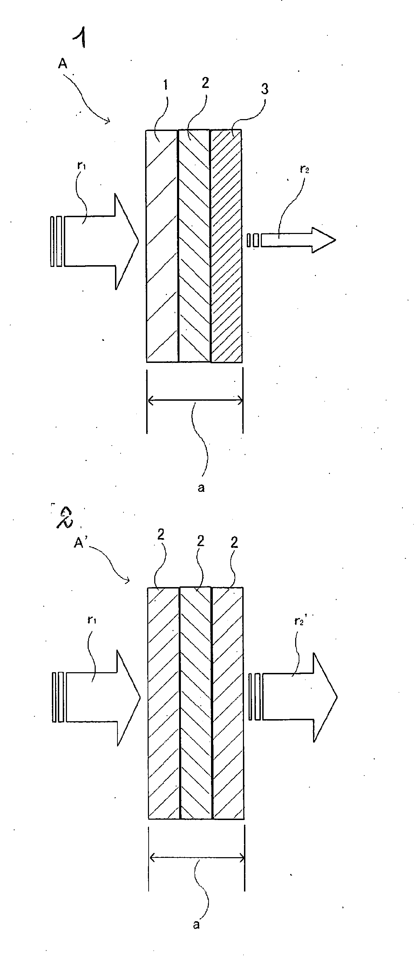

   FIG. 1 is a schematic longitudinal sectional view of an electromagnetic shield sheet for illustrating the configuration of an electromagnetic shield sheet according to Example 1 of the present invention.
[FIG. 2]
   FIG. 2 is a schematic longitudinal sectional view of an electromagnetic shield sheet for illustrating the configuration of the electromagnetic shield sheet according to Comparative Example 1 of the invention.
[FIG. 3]

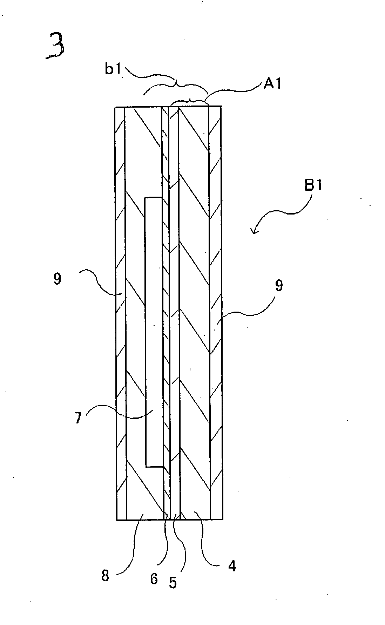

   FIG. 3 is a schematic longitudinal sectional view of an RFID plate obtained by layering an electromagnetic shield sheet and an antenna circuit, for illustrating a configuration example of the RFID (Radio Frequency Identification) plate according to the invention.
[FIG. 4]

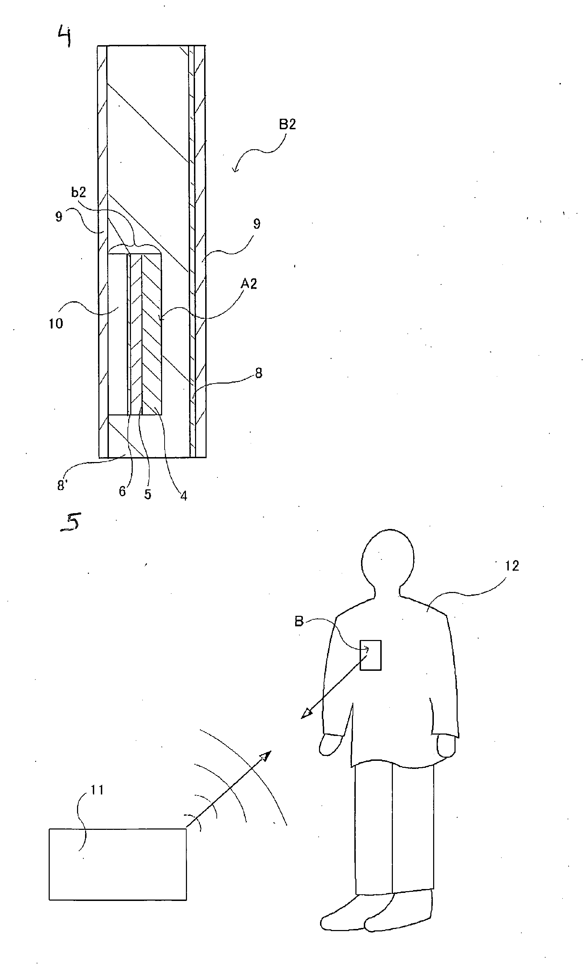

   FIG. 4 is a schematic longitudinal sectional view of an RFID plate obtained by layering an electromagnetic shield sheet and an IC-with-antenna, for illustrating another configuration example of the RFID (Radio Frequency Identification) plate according to the invention.
[FIG. 5]
   FIG. 5 is an illustration of a manner in which the RFID (Radio Frequency Identification) plate according to the invention is used.
[FIG. 6]

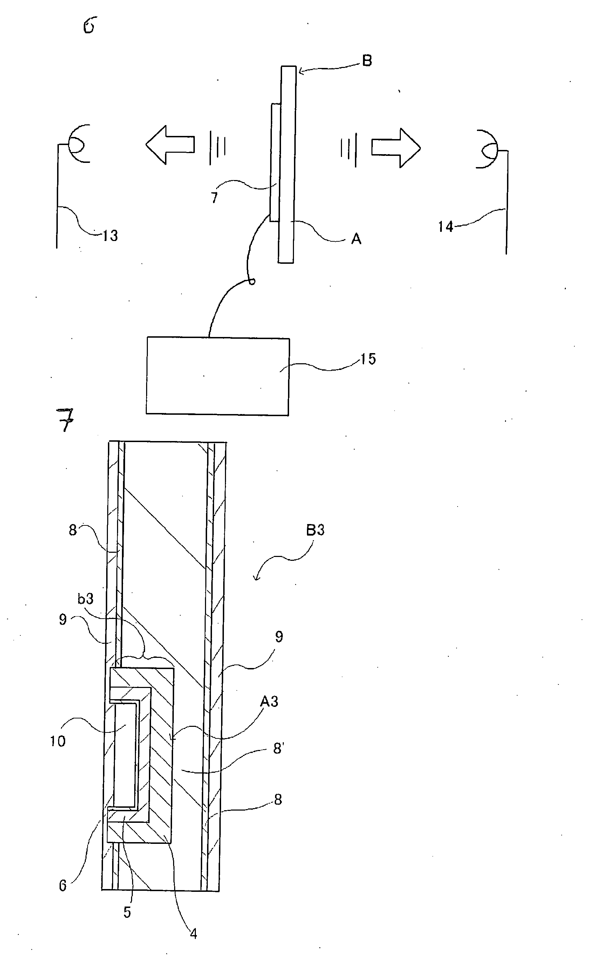

   FIG. 6 is a schematic view for illustrating an electromagnetic wave measuring method for the RFID plate obtained by layering an electromagnetic shield sheet and an antenna circuit which is used in Examples of the RFID (Radio Frequency Identification) plate according to the invention.
[FIG. 7]
   FIG. 7 is a schematic longitudinal sectional view of an RFID plate for illustrating a configuration of the RFID (Radio Frequency Identification) plate according to Example 16 of the invention.

### Description of Reference Numerals

A, A', A1, A2, A3: Electromagnetic shield sheet
B, B1, B2, B3: RFID (Radio Frequency Identification) plate
b1, b2, b3: Laminate
1, 2, 3: Polymer composition layer
4: Polymer composition layer (lamination)
5: Insulating polymer layer
6: Adhesive layer
7: Antenna or antenna circuit
8: Opaque layer (Recorded layer)
8': Card substrate
9: Cover layer
10: IC-with-antenna

### Best Mode for Carrying Out the Invention

Now, the present invention will be described in detail below. The electromagnetic shield sheet according to the present invention includes a polymer composition layer obtained by mixing a conductive material with a polymer material. In the electromagnetic shield sheet of the invention, the polymer material is not particularly limited in kind; for example, synthetic resins, natural resins, natural rubber, synthetic rubbers and other polymer materials having rubber-like elasticity commonly used as sheet material can be used. Among these materials, elastomers are preferable in view of making it possible to cope with ruggedness of, for example, circuit elements, or making it easy to obtain a desired shape, and in view of that the elastomers allow a larger contact portion and that they have a shock absorber effect. The elastomers are not particularly limited in kind. Examples of the elastomers which can be used include chloroprene rubber, silicone rubber, acrylic rubber, ethylene-propylene copolymer, butadiene-acrylonitrile copolymer, fluoro-rubber, and elastic resins such as urethane resin, elastic epoxy resin, silicone resin, silicone modified resin, fluoro-resin, etc., which may be used either singly or in appropriate combination of two or more of them and in the form of elastomer. In addition, since elastomers have good formability (moldability) and flexibility, they can be put into close contact with a circuit board and electronic component parts.

Among these elastomers, silicone rubbers are preferred taking into account their contribution to electromagnetic shielding effect and their formability (moldability), flexibility, heat resistance, etc. The silicone rubbers are not particularly limited in kind. Examples of the silicone rubbers which can be used preferably include commercially available ones such as methylvinylsilicone rubber, methylphenylvinylsilicone rubber, and fluorosilicone rubber, which may be used either singly or in combination of two or more of them. In addition, silicone rubbers are superior to other elastomers in regard of heat conduction. Therefore, for example in the case where an electromagnetic wave generating source is a component part serving as a heat source, a silicone rubber can be used favorably as a polymer material in a polymer composition layer or an insulating polymer layer (described later) which is located nearer to the heat source. Further, for example in the case where a carbon such as carbon fibers is loaded as a conductive material, as described later, silicone rubbers are preferred because it is easy to knead carbon fibers into silicone rubber. The carbon fibers are not particularly limited in length or aspect ratio. It is preferable, however, to use carbon fibers while selecting a length in the range of 0.1 to 12 mm, an aspect ratio in the range of 7 to 12000, and a diameter in the range of 1 to 20 µm.

The conductive material in the present invention is not particularly limited in kind, provided it is electrically conductive. Examples of the conductive material include: simple fibers of metals such as iron, aluminum, copper, silver, nickel, etc.; metallic fibers obtained by plating metallic or nonmetallic fibers with copper, nickel, or silver; powders of metals such as iron, aluminum, copper, silver, nickel, zinc, brass, bronze, etc.; particles obtained by coating surfaces of glass flakes by, for example, plating with silver, nickel, or the like; and carbons such as carbon fibers, etc. These conductive materials may be used either singly or in appropriate combination of two or more of them. Among these conductive materials, carbons are preferred. Examples of the carbons include Ketchen black, carbon fiber, graphite such as graphite powder, graphite fiber, etc., and carbon nanotube, etc., which may be used either singly or in appropriate combinations of two or more of them. Among these carbons, carbon nanotube and the like are more preferable, and joint use of carbon nanotube with other carbon is particularly preferable.

Too high a content of carbon fibers in the carbons with the polymer material tends to result in that the affinity between the polymer material and the carbon fibers is not sufficient, kneadability is lowered, the polymer composition layer in the sheet would be dry or crumbly, and the sheet has a lowered flexibility. In addition, there is also a tendency that electromagnetic shielding characteristics are varied when a pressure is exerted on the polymer composition layer obtained. In the case of carbon nanotube, an electromagnetic shielding effect comparable to that of a polymer composition layer obtained by mixing carbon fibers can be obtained by using the carbon nanotube in a smaller amount. Besides, the polymer composition layer obtained by mixing carbon nanotube shows a stable electromagnetic shielding effect even when a pressure is exerted thereon. Further, when a mixture of carbon nanotube with other carbon is used, a further enhanced electromagnetic shielding effect is obtained. Examples of the combination which can be used preferably include a mixture of carbon nanotube with Ketchen black.

In the case of using carbon nanotube and other carbon together, the mixing ratio can be appropriately selected according to the kind of the carbon or the like. For instance, the weight ratio of carbon nanotube to other carbon (carbon nanotube : other carbon) is preferably in the range of from 1:99 to 99:1, and more preferably from 30:70 to 90:10. The carbon nanotube is not particularly limited, provided it has a hollow cylindrical structure obtained by rounding a graphene sheet (an independent carbon hexagonal net plane). For instance, the carbon nanotube may be a single-wall nanotube (SWNT), a multi-wall nanotube (MWNT), or a cup stack nanotube; further, a multi-wall nanotube and a stack nanotube are preferred to a single-wall nanotube. Incidentally, the carbon nanotube is not particularly limited in diameter or length.

The mixing ratios of the polymer material and the conductive material in the polymer composition layer of the electromagnetic shield sheet according to the present invention are not particularly limited, and can be appropriately selected according to the kinds of the materials, the intended conductivity, and the like. For instance, where a carbon is used as the conductive material, the mixing amount of the carbon is preferably 2 to 150 parts by weight (parts by weigt per 100 parts by weigt of rubber, which will be referred to as "phr"; incidentally, the unit "phr" will be used even when other polymer material than rubber is used in the present invention) per 100 parts by weight of the polymer material, and it is preferable to laminatingly form at least two layers while changing the mixing ratio within this range. The mixing ratio of the carbon is more preferably 2 to 100 phr, further preferably 2 to 80 phr, and particularly preferably 3 to 70 phr. When the mixing ratio of the carbon to the polymer material is too low, it may be difficult to obtain the intended electromagnetic shielding effect. If the mixing ratio of the carbon is too high, electric characteristics similar to those of metal may result, and it may be difficult to obtain the shielding effect intended in the present invention.

The electromagnetic shield sheet according to the present invention has a structure in which at least two polymer composition layers having different dielectric constants are layered by mixing the conductive material, and, therefore, the raw material components of each layer may be the same or different. The difference(s) in dielectric constant between the layers is not particularly limited. For example, stepwise dielectric constant difference(s) between the layers can be appropriately controlled by regulating the difference(s) in the mixing amount of the conductive material, the difference(s) in the kind of the conductive material, or a combination of them. It is preferable to thus regulate the mixing amount of the conductive material in each of the polymer composition layers so that the polymer composition layers have different dielectric constants. For example, in the case where the raw material components of the polymer composition layers are the same, the stepwise difference(s) in the mixing amount (phr) of the conductive material based on 100 parts by weight of the polymer material between the layers is preferably in the range of 1 to 100 phr, more preferably 1 to 80 phr, further preferably 2 to 30 phr, and particularly preferably 3 to 20 phr. If the stepwise difference(s) in the mixing amount of the conductive material between the layers is too small, it may be difficult to obtain the shielding effect intended in the present invention, and, if the difference(s) is too large, the characteristics of the sheet may be liable to depend on the layer having a larger mixing amount (phr). Incidentally, in the case
where at least three polymer composition layers are layered, the layers may be so formed that the dielectric constant of each layer is increased sequentially, or may be layered at random. It is preferable, however, to form the layers so that the dielectric constant of each layer is increased sequentially. Besides, in the case where the layers are formed as polymer composition layers having different dielectric constants, it is preferable to form the polymer composition layers so that the mixing ratio of the conductive material to the polymer material in each layer is increased sequentially.

The electromagnetic shield sheet according to the present invention may be used in such a manner that the polymer composition layer having a higher dielectric constant, or a larger mixing amount of the conductive material, is located nearer to an electromagnetic wave generating source, or may be used in such a manner that the polymer composition layer having a lower dielectric constant, or a smaller mixing amount of the conductive material, is located nearer to the electromagnetic wave generating source. However, the use of the electromagnetic shield sheet in such a manner that the polymer composition layer being the lowest of the polymer composition layers in dielectric constant is located nearer to the electromagnetic wave generating source is more effective, since the amount of electromagnetic waves transmitted through each layer under the electromagnetic shielding effect is decreased stepwise. In addition, in the case where the polymer composition layer sheet including a plurality of polymer composition layers having different dielectric constants is a polymer composition layer sheet including three or more polymer composition layers, a highest shielding effect is obtained by arranging the polymer composition layers so that the dielectric constant is increased sequentially, or so that the mixing ratio of the conductive material to the polymer material is increased sequentially, as above-mentioned, i.e., so that the dielectric constant is varied from a lower value toward a higher value along the direction from the electromagnetic wave generating source, or so that the mixing ratio of the conductive material is varied from a lower value toward a higher value along the direction from the electromagnetic wave generating source. Therefore, even if a plurality of polymer composition layers in which the same conductive material is mixed in the same amount are integrally layered (a laminate type of same-dielectric-constant layers), the effect of the present invention cannot be obtained. In addition, in the case where the loading density of the conductive material is varied in each of the polymer composition layers, the effect of the present invention is developed, but there is difficulty in reproducibility of the density gradient, and reliability on a design basis is low. Besides, as for the manner of laminating the polymer composition layers, the layers may be so laminated that the polymer composition layer in a substantially central part in the direction from the polymer composition layer at the surface on one side of the sheet toward the polymer composition layer at the surface on the other side is the greatest in the mixing amount of the conductive material and that the mixing amount of the conductive material is decreased sequentially from the central layer toward the outer-side layers. This configuration enables the electromagnetic shield sheet to be used in an apparatus using circuit boards in a multi-layer fashion by inserting the sheet between the circuit boards, whereby electromagnetic shielding between the adjacent circuit boards can be achieved.

In addition to the polymer material and the conductive material mentioned above, it is possible to add a metal oxide (e.g., barium titanate, zinc oxide, magnesium oxide, or titanium oxide) or a metal hydroxide (e.g., aluminum hydroxide, or calcium hydroxide) or the like to the polymer composition layer in the present invention. Addition of such an additional component imparts thermal conductivity and flame retardancy to the polymer composition layer. In adding these additional components, a layer may be newly provided on the outer side of the polymer composition layer which is loaded with the conductive material. Besides, a plasticizer or a processing aid may be added, as required. Addition of a plasticizer or a processing aid makes it possible to improve processibility. Examples of the plasticizer and the processing aid include silicone oils. Further, for example, a foaming agent may also be added. Addition of a foaming agent makes it possible to obtain a lighter blank material. Examples of the foaming agent which can be used include volatile-type foaming agents such as carbon dioxide gas and ammonium gas, decomposition-type foaming agents such as azodicarbondiamide and dinitrosopentamethylenetetramine, organic balloons, and inorganic balloons. In consideration of uniformity and stability of the blank material, use of expanded organic balloons or expanded inorganic balloons is preferred. In the case of adding expanded organic balloons or expanded inorganic balloons, the addition amount is not particularly limited, and may be appropriately selected according to the intended specific weight, for example. Taking into account processibility as well as the strength of the formed (molded) product and the like, the addition amount of the organic balloons per 100 parts by weight of the polymer material is preferably not more than 5 phr, more preferably in the range of 1 to 5 phr, and that of the inorganic balloons is preferably not more than 25 phr, more preferably in the range of 5 to 25 phr. Naturally, both the organic balloons and the inorganic balloons may be used together. In addition, where silicone rubber is used as the polymer material, vulcanization of the silicone rubber is not limited to that conducted by use of an organic peroxide; naturally, vulcanizing methods based on the use of radiations or an addition reaction may also be used. Particularly, the method based on the use of an addition reaction makes it possible to obtain a good formed (molded) product and to obtain a formed (molded) product even at low temperatures, by adding hydrogenpolysiloxane as the crosslinking agent, a platinum complex as a catalyst, and methylvinylcyclotetrasiloxane or acetylene alcohol or the like as a reaction inhibitor, in small amounts. Besides, silicone polymers include those which are marketed in the state of being loaded with silica, and such silicone compounds can also be used preferably.

In producing the electromagnetic shield sheet according to the present invention, the polymer material serving as a raw material component of each polymer composition layer is admixed with the conductive material and optionally with a kneading aid, a curing agent or other components, the admixture is kneaded by use of rolls, a kneader or the like, then each layer is formed into a sheet-like shape by a general polymer material forming method, and the layers are laminated with each other; or, alternatively, the layers are integrally formed by a general polymer material forming method to obtain a laminate sheet. Also, a laminate sheet may be formed simultaneously with extrusion by use of a coextruder. Examples of the general forming method which can be used include molding such as press molding, injection molding, transfer molding, etc., extrusion, and calendaring; where the materials are liquid, such methods as potting, casting, and screen printing can also be adopted. Among these methods, preferred are press molding and extrusion. In addition, examples of the method for laminating the layers thus formed in a sheet-like shape include adhesion, fusing, solvent welding, press molding, vulcanization, and polymerization. Further, examples of the method for lamination by integral forming include coextrusion and co-injection molding.

In the electromagnetic shield sheet according to the present invention, the thickness of each of the polymer composition layer is not particularly limited. For example, the layers may be the same or different in thickness. In the case where the layers have the same thickness, the thickness of each layer is preferably 0.05 to 5 mm, more preferably 0.1 to 2 mm. When the thickness of each layer is too small, the dielectric characteristics intended in the present invention may be difficult to obtain. When the thickness of each layer is too large, on the other hand, though the dielectric characteristics can be secured without being affected adversely, the flexibility also intended in the present invention may be difficult to obtain, so that the use of the electromagnetic shield sheet obtained may be limited. In addition, the thickness of the electromagnetic shield sheet is not particularly limited, and may be appropriately selected according to the intended use of the sheet, the frequency of the electromagnetic waves in consideration, and the like factors. For the same reasons as above, however, the total thickness of the electromagnetic shield sheet is preferably 0.2 to 15 mm, more preferably 0.5 to 5 mm.

In the electromagnetic shield sheet according to the present invention, an insulating polymer layer may further be formed on a layer of the polymer composition layers laminated. The insulating performance of the insulating polymer layer is controlled according to the use for which the electromagnetic shield sheet is used, specifically, in such a manner as to fulfill the reliability demanded. For example, in the case where the electromagnetic shield sheet is used for an electronic circuit board, the sheet may be a layer composed only of the same polymer material obtained when the conductive material mixed in the polymer composition layers is removed. More specifically, the insulating polymer layer preferably has a surface insulation resistance highly by not less than 10⁴ Ω·cm, preferably not less than 10⁵ Ω·cm, particularly not less than 10⁷ Ω·cm than that of the polymer composition layer located nearest to the object to be shielded, such as a circuit board, of the layers of the electromagnetic shield sheet. In the case where the insulating polymer layer is thus layered on the polymer composition layer, when the electromagnetic shield sheet of the invention is put into close contact with a circuit board, for example, it is possible to eliminate the possibility of shortcircuiting in the electronic circuitry.

In the case where the electromagnetic shield sheet according to the present invention has the insulating polymer layer laminated as above-mentioned, taking insulation efficiency or the like into account it is preferable for the insulating polymer layer to be layered on the side of the polymer composition layer having a lower dielectric constant, or be layered on the side of the polymer composition layer having a lower mixing ratio of the conductive material. According to the intended use of the electromagnetic shield sheet, however, the insulating polymer layer may be provided on the side opposite to the just-mentioned side or provided on both sides. The insulating polymer material forming the insulating polymer layer is not particularly limited in kind, provided that it has an insulating property. Examples of the insulating polymer material which can be used include elastomers such as natural rubber, synthetic rubbers such as silicone rubber, ethylene-propylene copolymer, butadiene-acrylonitrile copolymer, fluoro-rubber, urethane resin, and elastic epoxy resin, which may be used either singly or in combination of two or more of them. Among these materials, silicone rubbers are superior to other elastomers in heat conduction, as above-mentioned; therefore, for example when the electromagnetic shield sheet is used as one for a component part in which the electromagnetic wave generating source is a heat source, use of silicone rubber is preferred, taking into account the heat radiating effect or the like.

In the case of laminating the insulating polymer layer in the electromagnetic shield sheet according to the present invention, loading the insulating polymer layer with a magnetic material powder is preferred, since it is thereby possible to provide an electromagnetic absorbing function, and, for example, to absorb electromagnetic waves generated in some circuit elements, thereby eliminating reflection-derived electromagnetic interference imposed on other circuit elements present in the vicinity of the some circuit elements in the same circuit board. In this case, electromagnetic waves coming from external environments are shielded by the polymer composition layer laminated on the insulating polymer layer. The magnetic material powder mixed into the insulating polymer layer is not particularly limited in kind. Examples of the magnetic material powder which can be used here include ceramic powders, various ferrite powders, cobalt magnet powders, alnico magnet powders, and permalloy powders, which may be used either singly or in combination of two or more of them. Among these powders, ceramic powders and the like are particularly preferred, taking into account their being able to release the heat of an electromagnetic wave generating source to the exterior. With the heat conducting function thus imparted to the insulating polymer layer, heat generated from the electronic circuitry can also be released to the exterior.

The electromagnetic shield sheet according to the present invention is enhanced in convenience when the sheet is provided with a pressure sensitive adhesive surface, which is preferable. The presence of a pressure sensitive adhesive surface provides the sheet with free-installability for disposing the sheet onto an inner wall of a box or case body, for example, and ensures that the sheet is unlikely to fall off position even when subjected to vibration or the like. The means for rendering a surface of the sheet pressure sensitive adhesive is not particularly limited, and an appropriate kind of pressure sensitive adhesive or an appropriate means may be selected; for example, subjecting the sheet surface to a corona discharge treatment and then coating the surface with an acrylic pressure sensitive adhesive to form an acrylic pressure sensitive adhesive layer may be adopted. In the case where the electromagnetic shield sheet according to the invention is one in which an insulating polymer layer is laminated, provision of the insulating polymer layer with a pressure sensitive adhesive surface is preferred, taking into account the pressure sensitive adhesion of the sheet to a circuit board or the like. In the case where pressure sensitive adhesion of the sheet to a circuit board is conducted, it is preferable that the pressure sensitive adhesive layer itself is insulating so that shortcircuiting would not occur in the circuitry even upon passage of a current. In addition, in the cases where remaining of the pressure sensitive adhesive on the adherend is to be avoided,
where a weak adhesion suffices, or where it is intended to frequently detach the sheet from the adherend, the pressure sensitive adhesive layer may be replaced by a tack layer which can be attached to, detached from and put into close contact with an adherend, if the adherend has a smooth body surface. When addition of a functional layer(s) or provision of an additional layer(s) combinedly with a function(s), such as the insulating polymer layer, addition of an electromagnetic absorbing function, an additional layer(s) having a heat conducting function and/or a pressure sensitive adhesive function is adopted, the electromagnetic shield sheet according to the invention can be widened in scope of use. Therefore, such additional layers may be provided by appropriately loading the polymer material with fillers having various functions or by using only the functional polymer materials, within such ranges as not to hamper the electromagnetic shielding effect. In the case of the present invention, the electromagnetic shield sheet may not necessarily be used directly as a sheet, and the electromagnetic shield sheet can be formed into a cap for a specific element serving as an electromagnetic wave generating source and be attached to the element.

The electromagnetic shield sheet according to the present invention can not only be used as a shield for electromagnetic waves generated from a circuit board or an electromagnetic wave generating source, but also be utilized for RFID (Radio Frequency Identification), which is one of valuable uses for the invention. The RFID plate according to the invention has a laminate of the electromagnetic shield sheet with an integrated circuit (IC) and/or an antenna circuit, such as an IC-with-antenna obtained by packaging an integrated circuit (IC). The RFID plate of the invention may be the laminate itself obtained by laminating the electromagnetic shield sheet with an IC and/or an antenna circuit. Or, alternatively, the laminate obtained by combining the RFID plate with at least one of an integrated circuit (IC) and an antenna circuit may be used together with an appropriate member, to be used as a card, tag, or label such as an IC-with-antenna tag, label, readable card, name plate, etc. Here, the IC-with-antenna used for the RFID plate according to the invention may be, for example, one obtained by packaging an antenna with an integrated circuit (IC) such as an IC chip. A specific example is one in which a printed antenna having a size of up to 10 cm at maximum and used for a frequency range of several tens of megahertz to 1 GHz is combined with an auto-identifying/reading miniature IC with a size of not more than 1 mm. In this case, the IC has, designed and incorporated therein, a circuit capable of transmitting a signal from the antenna in response to a signal received at the antenna. In addition, as the antenna circuit, those of various forms such as printed antenna circuit can be used. The electromagnetic shield sheet of the invention is particularly effective when it can be used in the laminated sheet-like form or after the sheet is deformed while maintaining the laminated state, in its use for protection or shielding in conjunction with reception/transmission of signals.

Now, a configuration example of the RFID plate according to the present invention will be described below referring to the drawings. FIG. 3 is a schematic longitudinal sectional view of an RFID plate B1, schematically representing a section of a portion where a printed antenna circuit is arranged in a configuration example of an RFID plate of the invention wherein the printed antenna circuit is combined with a two-layer laminate type electromagnetic shield sheet. The RFID plate B1 has the above-mentioned electromagnetic shield sheet A1 of the invention, which has a polymer composition layer 4 obtained by laminating two polymer composition layers having different dielectric constants (in the figure, the laminated state is omitted from presentation), with an insulating polymer layer 5 laminated on the side of the polymer composition layer having the lower dielectric constant. A printed antenna circuit 7 is adhered to the insulating polymer layer 5 side, through an adhesive layer 6 optionally provided therebetween, to form a laminate b1. An opaque layer (recorded layer) 8 composed of an opaque recordable synthetic paper or the like is adhered to the printed antenna circuit 7 side of the laminate b1, a desired indication is applied to the opaque layer (recorded layer) 8 by printing or writing or the like, and cover layers 9, 9 are provided on the surfaces (back and face surfaces) if necessary, to form the RFID plate B1. The RFID plate B1 can be used as a name plate (name card). When the RFID plate B1 is attached to a person, the whereabouts of the person will be clear. In addition, the RFID plate B1 becomes a high-safety name plate or the like which would not impose electromagnetic interference on human bodies. Particularly when an elastomer such as silicone is used as the polymer material, the plate as a whole becomes flexible without stiffness, so that the plate can be attached to underwear or the like, and integrity of the plate with the human body can be secured, independently of whether upper garments are put on or taken off. In addition, when a pressure sensitive adhesive layer (not shown) is provided on the side of the polymer composition layer having the higher dielectric constant of the electromagnetic shield sheet A1, through the optionally provided cover layer 9 therebetween, the RFID plate B1 can be made to be a label or tag which can be adhered to a surface of a human body or luggage or the like. The RFID plate according to the present invention configured in this manner can be used for individual identification, identification of position/movement of an individual, or authentication of an individual, and is serviceable for security.

In the next place, FIG. 4 is a schematic longitudinal sectional view of an RFID plate B2, schematically representing a section of a portion where an IC is arranged in another configuration example of the RFID plate according to the present invention wherein an IC-with-antenna is combined with a two-layer laminate type electromagnetic shield sheet. The RFID plate B2 has an electromagnetic shield sheet A2 in which two polymer composition layers having different dielectric constants are laminated to form a polymer composition layer 4 (in the figure, the laminated state is omitted from presentation), with an insulating polymer layer 5 laminated on the side of the polymer composition layer having the lower dielectric constant. Further, an IC-with-antenna 10 is adhered to the insulating polymer layer 5, through an adhesive layer 6 therebetween, to form a laminate b2. On the other hand, a card substrate 8' is prepared which is provided with a recess having substantially the same area as that of the laminate b2. The laminate b2 is embedded in the recess of the card substrate 8' in the condition where the side of the polymer composition layer having the higher dielectric constant of the polymer composition layer 4 of the laminate b2 is adhered to the bottom surface of the recess in the card substrate 8', through an adhesive layer (not shown) therebetween. It is favorable that the card substrate 8' has a surface on which an indication can be printed or written, if necessary. A cover layer 9 is provided on the IC-with-antenna 10 side of the laminate b2. Here, when that portion of the cover layer which is slightly wider than the IC-with-antenna portion embedded is opaque, the antenna circuit and the like are externally invisible, resulting in enhanced security. Besides, an opaque layer (recorded layer) 8 composed of an opaque recordable synthetic paper or the like is adhered to the surface of the card substrate 8' on the side opposite to the side of the IC-with-antenna 10, a desired indication is applied to the opaque layer (recorded layer) 8 by printing or writing or the like, and a cover layer 9 is further provided on the surface, as required. This RFID plate B2 also can be used as an IC tag or name plate (name card). Naturally, the opaque layer (recorded layer) 8 may be adhered to the whole part of the card substrate 8' on the IC-with-antenna 10 side. In addition, when the cover layer is sealed at end faces of the RFID plate, water-proofness is enhanced. Thus, in various kinds of cards, the side of the polymer composition layer having the lower dielectric constant of the electromagnetic shield sheet according to the present invention may be laminated through an insulating layer onto the IC-with-antenna surface, on the side opposite to the reading machine side, of the IC-with-antenna embedded in a part of the card, whereby cards which are extremely high in electromagnetic reading efficiency and are preferable for non-contact authentication technology can be realized.

In using the RFID plate according to the present invention, as shown in FIG. 5, for example, the RFID plate B may be adhered or attached by a pin to the surface of clothing on a human body 12, whereby identification of the position/movement of an individual or authentication of an individual can be realized using a recognition apparatus 11. Here, when the RFID plate of the invention is one in which an IC-with-antenna is laminated, the RFID plate is so located that the reading side for the IC-with-antenna is on the face side, i.e., the reading side for the IC-with-antenna is directed toward the recognition apparatus 11. The configuration of the present invention is not limited to the above-described configuration, and various modifications are possible within the scope of the gist of the invention.

The electromagnetic shield sheet according to the present invention not only can simply enhance the electromagnetic shielding effect but also can, when combined with an IC-with-antenna or an antenna circuit, transmit a signal through the antenna or efficiently transmit a signal received by the antenna, as a reflected signal, and can add a directionality in transmission. Further, when the shape of the electromagnetic shield sheet is changed by pressing or the like so that the periphery of the IC-with-antenna or antenna circuit is raised like a brim of a dish and the thus deformed sheet is put into close contact with an adherend, the directivity of the electromagnetic wave signal received by or transmitted from the IC-with-antenna or antenna circuit can be further enhanced. When an elastomer is selected as the polymer material, its formability (moldability) and flexibility ensures that a circuit board can be easily put into firm contact with the formed (molded) electromagnetic shield sheet.

Besides, the electromagnetic shield sheet according to the present invention is extremely high in electromagnetic shielding effect, and it can be made thinner accordingly. Consequently, for example, the sheet can be applied also to an IC-with-antenna embedded in a card, like the above-mentioned RFID plate B2, without causing any trouble with respect to thickness. According to the present invention, there can be provided an electromagnetic shield sheet which is high in accuracy and efficiency even though small in thickness, so that it shows enhanced convenience, as compared with conventional ones, even when applied to a tag or label.

### Examples

Now, the present invention will be described specifically by showing examples, but the invention is not to be limited to the following examples.

### [Example 1]

A silicone rubber (trade name "DY32-152U," produced by Dow Corning Toray Co., Ltd.) in an amount of 100 parts by weight was kneaded respectively with 5 phr, 10 phr, and 20 phr of carbon fibers (trade name "XN-10C," produced by Nippon Graphite Fiber Corp.) having a diameter of 10 µm and a length of 3 mm, followed by press molding. As a result, an electromagnetic shield sheet A of Example 1 as shown in FIG. 1 was obtained which had a total thickness (indicated by arrows (a) in the figure) of 3 mm and in which a polymer composition layer 1 having a carbon fiber mixing ratio of 5 phr based on 100 parts by weight of the silicone rubber, a polymer composition layer 2 having a carbon fiber mixing ratio of 10 phr, and a polymer composition layer 3 having a carbon fiber mixing ratio of 20 phr were sequentially and integrally molded, with the thickness of each layer being 1 mm.

### [Example 2]

An electromagnetic shield sheet of Example 2 was obtained in the same manner as in Example 1, except that the molding was so performed that the thickness of each of the polymer composition layers 1, 2, 3 was 0.5 mm and the total thickness of the sheet was 1.5 mm.

### [Comparative Example 1]

The process of Example 1 was carried out in the same manner as in Example 1, except that the kneading was so conducted that the mixing ratios of the carbon fibers based on 100 parts by weight of the silicone rubber were respectively 11 phr, 11 phr, and 11 phr. As a result, an electromagnetic shield sheet A' of Comparative Example 1 as shown in FIG. 2 was obtained which had a total thickness (indicated by arrows (a) in the figure) of 3 mm and in which polymer composition layers 2, 2, 2 each having a carbon fiber mixing ratio of 11 phr were integrally molded, with the thickness of each layer being 1 mm.

### [Comparative Example 2]

The process of Example 1 was carried out in the same manner as in Example 1, except that the kneading was so performed that in place of the carbon fibers, a barium titanate powder (produced by Nacalai Tesque, Inc.) was used in respective amounts of 5 phr, 10 phr, and 20 phr based on 100 parts by weight of the silicone rubber, so as to form insulating polymer layers containing the magnetic material powder in place of the polymer composition layers 1, 2, 3 containing the carbon fibers (conductive material). As a result, an electromagnetic shield sheet of Comparative Example 2 was obtained.

The electromagnetic shield sheets of Examples 1 and 2 and the electromagnetic shield sheets of Comparative Examples 1 and 2 were subjected to measurement of electromagnetic characteristics by the Advantest method. The electromagnetic shield sheets of Examples 1 and 2 were each irradiated with an electromagnetic wave of 1 GHz from the side of the polymer composition layer containing 5 phr of the carbon fibers based on 100 parts by weight of the silicone rubber. The electromagnetic shield sheet of Comparative Example 2 was irradiated with the electromagnetic wave of 1 GHz from the side of the polymer layer containing 5 phr of barium titanate based on 100 parts by weight of the silicone rubber. Upon irradiation with the 1 GHz electromagnetic wave, the amount of electromagnetic wave transmitted r₂ was measured, and the amount of electromagnetic wave shielded r₃ was determined, with the amount of incident electromagnetic wave r₁ taken as 100. The results are shown in Table 1 below.

**[Table 1]**

| | Amount of electromagnetic wave (relative amount) incident on polymer composition layer surface on irradiation side | Amount of electromagnetic wave transmitted | Evaluation: Amount of electromagnetic wave shielded |
|---|---|---|---|
| | r₁ | r₂ | r₃ |
| Example 1 | 5 phr polymer composition layer surface | | |
| | 100 | 20 | 80 |
| Example 2 | 5 phr polymer composition layer surface | | |
| | 100 | 30 | 70 |
| Comparative Example 1 | 11 phr polymer composition layer surface | | |
| | 100 | 89 | 11 |
| Comparative Example 2 | 5 phr insulating polymer layer surface | | |
| | 100 | 50 | 50 |

In Table 1, the results of Example 1 and the results of Comparative Example 1 are compared with each other. It is seen that in the case where the carbon fibers in the same amount were mixed into the silicone rubber of the electromagnetic shield sheet, the electromagnetic shield sheet in which the polymer composition layers different in carbon fiber mixing ratio were sequentially laminated was smaller in the amount of electromagnetic wave transmitted and higher in electromagnetic shielding effect, as compared with the electromagnetic shield sheet in which the polymer composition layers having the same carbon fiber mixing ratio were laminated. It is also seen that a reduction in the thickness of the sheet leads to a reduction in the electromagnetic shielding effect (Example 2), but this shielding effect is still higher than that of the sheet of Comparative Example 2 in which barium titanate was used in place of the carbon fibers of Example 1.

### [Comparative Example 3]

A sheet having a thickness of 3 mm was formed by adopting the same mixing condition as the central polymer composition layer in the sheet of Example 1. The sheet was centrifuged for 1 min in such a condition that a centrifugal force was applied perpendicularly to the sheet plane, so as to partly sediment the carbon fibers in the sheet, thereby creating a distribution of the carbon fibers in the sheet section direction (thickness direction), followed by press molding, to obtain an electromagnetic shield sheet of Comparative Example 3. With the sheet so disposed that the side of the lower carbon fiber distribution density was facing the electromagnetic wave generating source, the test and evaluation was carried out in the same manner as in Example 1. Though the test was repeated in the same conditions, the electromagnetic characteristics were dispersed considerably, and reliability was not obtainable, as compared with the laminate type sheet of Example 1.

### [Example 3]

A transparent silicone rubber layer formed of a silicone rubber (trade name "BY32-152U," produced by Dow Corning Toray Co., Ltd.) and having a thickness of 1 mm was provided on the side of the polymer composition layer 1 containing 5 phr of the carbon fibers of the electromagnetic shield sheet of Example 1, at the time of integral molding. The transparent silicone rubber layer was subjected to a corona discharge treatment, and was thinly coated with a silicone pressure sensitive adhesive layer (trade name "KE4805," produced by Shin-Etsu Chemical Co., Ltd.), to obtain a pressure sensitive adhesive electromagnetic shield sheet as electromagnetic shield sheet of Example 3. Two such sheets were prepared, and were adhered respectively to the face and back sides of an electronic circuit board with circuit elements arranged therein, by utilizing the pressure sensitive adhesive layers, to obtain a circuit board protected from electromagnetic waves. The electromagnetic shield sheets would not peel off even when the circuit board thus obtained was vibrated.

### [Example 4]

An electromagnetic shield sheet of Example 4 was obtained in the same manner as in Example 3, except that a magnetic material powder containing layer containing 40 phr of barium titanate (produced by Nacalai Tesque, Inc.) based on 100 parts by weight of the silicone rubber was laminated in place of the transparent silicone rubber layer of Example 3. The electromagnetic shield sheet, of which the magnetic material powder containing layer is disposed closest to the circuit board, can diffuse the heat of the circuit board to the exterior.

### [Example 5]

An electromagnetic shield sheet of Example 5 was obtained in the same manner as in Example 1, except that carbon nanotubes (commercial MWNT) were used in place of the carbon fibers of Example 1.

### [Example 6]

An electromagnetic shield sheet of Example 6 was obtained in the same manner as in Example 5, except that 50 wt% of the carbon nanotubes used in Example 5 were replaced by the carbon fibers used in Example 1 and the resulting mixture was used.

### [Comparative Example 4]

An electromagnetic shield sheet of Comparative Example 4 was obtained in the same manner as in Comparative Example 1, except that carbon nanotubes (commercial MWNT) were used in place of the carbon fibers of Comparative Example 1.

The electromagnetic shield sheets of Examples 5 and 6 and Comparative Example 4 were evaluated as to electromagnetic characteristics in the same manner as in Example 1 and Comparative Example 1. The results are shown in Table 2 below.

**[Table 2]**

| | Amount of electromagnetic wave (relative amount) incident on polymer composition layer surface on irradiation side | Amount of electromagnetic wave transmitted | Evaluation: Amount of electromagnetic wave shielded |
|---|---|---|---|
| Example 5 | 5 phr polymer composition layer surface | | |
| | 100 | 10 | 90 |
| Example 6 | 5 phr polymer composition layer surface | | |
| | 100 | 5 | 95 |
| Comparative Example 4 | 11 phr polymer composition layer surface | | |
| | 100 | 50 | 50 |

From the results of Example 5 in Table 2, it is seen that when the carbon fibers are replaced by carbon nanotubes and polymer composition layers differing in carbon nanotube mixing ratio are sequentially laminated, the electromagnetic shield sheet obtained shows an enhanced electromagnetic shielding effect. It is seen from the results of Example 6 that when a mixture of carbon nanotubes and carbon fibers is blended into a silicone resin, a further enhanced electromagnetic shielding effect is obtained. The electromagnetic shield sheet in which polymer composition layers having the same carbon nanotube mixing ratio are laminated (Comparative Example 4) does not show an enhanced electromagnetic shielding effect.

### [Example 7]

An electromagnetic shield sheet of Example 7 having a total thickness of 1.5 mm was obtained in the same manner as in Example 2, except that particles obtained by coating glass flakes with silver (trade name "Metashine MC5480PS," major diameter: 80 µm, produced by Nippon Sheet Glass Co., Ltd.) were used in place of the carbon fibers of Example 2.

### [Comparative Example 5]

An electromagnetic shield sheet of Comparative Example 5 having a total thickness of 1.5 mm was obtained in the same manner as in Comparative Example 1, except that particles obtained by coating glass flakes with silver (trade name "Metashine MC5480PS," major diameter: 80 µm, produced by Nippon Sheet Glass Co., Ltd.) were used in place of the carbon fibers of Comparative Example 1.

The electromagnetic shield sheets of Example 7 and Comparative Example 5 were evaluated as to electromagnetic characteristics in the same manner as in Example 1 and Comparative Example 1. The results are shown in Table 3 below.

**[Table 3]**

| | Amount of electromagnetic wave (relative amount) incident on polymer composition layer surface on irradiation side | Amount of electromagnetic wave transmitted | Evaluation: Amount of electromagnetic wave shielded |
|---|---|---|---|
| Example 7 | 5 phr polymer composition layer surface | | |
| | 100 | 50 | 50 |
| Comparative Example 5 | 11 phr polymer composition layer surface | | |
| | 100 | 70 | 30 |

It was confirmed that also in the cases of the electromagnetic shield sheets using the particles obtained by coating glass flakes with silver, the electromagnetic shield sheet in which the polymer composition layers different in particle mixing ratio are laminated produces an enhanced electromagnetic shielding effect, as compared with the electromagnetic shield sheet in which the polymer composition layers having the same particle mixing ratio are laminated. It was also confirmed, however, that these sheets were inferior in electromagnetic shielding effect to the sheets using the carbon fibers.

### [Examples 8 to 13, Comparative Examples 6 to 20]

The conductive materials shown in Tables 4 to 7 in the amounts (phr) shown in the tables were respectively mixed into 100 parts by weight of a silicone rubber (trade name "DY32-152U," produced by Dow Corning Toray Co., Ltd.), followed by press molding, to produce electromagnetic shield sheets (electromagnetic shielding sheets) A (see FIG. 6). It is to be noted here that in the examples with "copper mesh" described in the column of filler, a copper mesh was used as it was in place of the polymer composition layer, and the numerical values set forth in the column of loading are the mesh sizes of the copper meshes. In a two-layer configuration of copper meshes, the meshes were placed in parallel to each other, with a spacing of 0.5 mm therebetween. In addition, in the examples with "aluminum foil" described in the column of filler, aluminum foils were used as they were in place of the polymer composition layers. The electromagnetic shield sheet specimens were all 0.5 mm in thickness. To each of the sheets A, a printed antenna circuit 7 (see FIG. 6) was adhered by use of a silicone rubber adhesive (trade name "SE9186 L," produced by Toray Industries, Inc.), to obtain an RFID plate B (see FIG. 6). In this case, the silicone rubber adhesive constitutes an insulating layer. Incidentally, in the electromagnetic shield sheet in which the polymer composition layers having different dielectric constants were laminated, the antenna circuit was adhered to the side of the polymer composition layer having the lower dielectric constant. As shown in FIG. 6, the antenna circuit 7 connected to a transmitter 15 was used as a 1 GHz transmission source, the left side thereof was set as the side of an RFID recognition apparatus, or a free space for electromagnetic waves was assumed, where a reflection-side receiver 13 was arranged, and the propagated electromagnetic wave was measured as reflection-side received power. The right side of the RFID plate B was set as the side of the adherend such as a human body or luggage, where a transmission-side receiver 14 was arranged, and the electromagnetic wave propagated (transmitted) through the electromagnetic shield sheet A was measured as transmission-side received power. The results are jointly shown in Tables 4 to 7. Incidentally, the conductive materials set forth in the tables were as follows.

### Carbon fiber:

Produced by Donac Co., Ltd., 700 µm in length, 13 µm in diameter

### Scaly graphite:

Average diameter: 10 µm, scaly (a sheet-like graphite obtained by firing a 50 µm-thick polyimide film at 2600°C was cut to about 5 mm square pieces, which were treated by a jet milling method, to obtain a powder having an average particle diameter of 10 µm)

### Carbon nanotube:

Produced by Nano Carbon Technologies Co., Ltd., 20 to 60 nm in diameter, 1 to 40 µm in length

### Aluminum foil:

Produced by Toyo Aluminium K.K., 200 µm in thickness

### Ketchen black:

Produced by Mitsubishi Chemical Corp., 34 nm in particle diameter

### Nickel powder:

Produced by Kanto Chemical Co., Inc., 3 to 7 µm Copper mesh:
Article on the market

**[Table 4]**

| Electromagnetic shield sheet | | | Comp. Ex. 6 | Comp. Ex. 7 | Ex. 8 | | Comp. Ex. 8 | Comp. Ex. 9 | Ex. 9 | |
|---|---|---|---|---|---|---|---|---|---|---|
| Filler | Kind | | Carbon fiber | | | | Scaly graphite | | | |
| | Loading (phr) | | 50 | 100 | 50 | 100 | 50 | 100 | 50 | 100 |
| Polymer composition layer | Layer configuration | | Mono-layer | mono-layer | two-layer laminate | | mono-layer | mono-layer | two-layer laminate | |
| | Thickness (mm) | | 0.5 | 0.5 | 0.25 each | | 0.5 | 0.5 | 0.25 each | |
| | | | | | 0.5 in total | | | | 0.5 in total | |
| Reflection-side received power/Output | | (mW) | 180/200 | 190/200 | 190/200 | | 184/200 | 190/200 | 190/200 | |
| Transmission-side received power/Output | | (mW) | 60/200 | 40/200 | 35/200 | | 42/200 | 24/200 | 20/200 | |

**[Table 5]**

| Electromagnetic shield sheet | | | Comp. Ex. 10 | Comp. Ex. 11 | Ex. 10 | | Comp. Ex. 12 |
|---|---|---|---|---|---|---|---|
| Filler | Kind | | Carbon nanotube | | | | Aluminum foil |
| | Loading (phr) | | 50 | 100 | 50 | 100 | - |
| Polymer composition layer | Layer configuration | | monolayer | monolayer | two-layer laminate | | monolayer |
| | Thickness (mm) | | 0.5 | 0.5 | 0.25 each | | 0.2 |
| | | | | | 0.5 in total | | |
| Reflectio-side received power/Output | | (mW) | 190/200 | 190/200 | 180/200 | | 180/200 |
| Transmission-side received power/Output | | (mW) | 20/200 | 8/200 | 5/200 | | 140/200 |

**[Table 6]**

| Electromagnetic shield sheet | | | Comp. Ex. 13 | Comp. Ex. 14 | Ex. 11 | | Comp. Ex. 15 | Comp. Ex.16 | Comp. Ex. 17 | |
|---|---|---|---|---|---|---|---|---|---|---|
| Filler | Kind | | Nickel powder | | | | Copper mesh | | | |
| | Loading (phr) | | 50 | 100 | 50 | 100 | 42.5 mesh | 80 mesh | 42.5 | 80 |
| | | | | | | | | | mesh | |
| Polymer composition layer | Layer configuration | | mono-layer | mono-layer | two-layer laminate | | mono-layer | mono-layer | two-layers in parallel | |
| | Thickness (mm) | | 0.5 | 0.5 | 0.25 each | | - | - | - | |
| | | | | | 0.5 in total | | | | | |
| Reflection-side received power/Output | | (mW) | 200/200 | 200/200 | 190/200 | | 200/200 | 200/200 | 190/200 | |
| Transmission-side received power/Output | | (mW) | 130/200 | 124/200 | 110/200 | | 80/200 | 70/200 | 60/200 | |

**[Table 7]**

| Electromagnetic shield sheet | | | Comp. Ex.18 | Comp. Ex.19 | Comp. Ex.20 | Ex. 12 | | Ex. 13 | |
|---|---|---|---|---|---|---|---|---|---|
| Filler | Kind | | Ketchen black (KB)/Carbon nanotube (CNT) (Carbons loaded in mixture) | | | | | | |
| | Loading | KB | 30 | 20 | 10 | 1.25 | 2.5 | 5 | 10 |
| | (phr) | CNT | 70 | 80 | 90 | 5 | 10 | 20 | 40 |
| Polymer composition layer | Layer configuration | | mono-layer | mono-layer | mono-layer | two-layer laminate | | two-layer laminate | |
| | Thickness (mm) | | 0.5 | 0.5 | 0.5 | 0.25 each | | 0.25 each | |
| | | | | | | 0.5 in total | | 0.5 in total | |
| Reflection-side received power/Output | | (mW) | 190/200 | 190/200 | 190/200 | 200/200 | | 200/200 | |
| Transmission-side received power/Output | | (mW) | 5/200 | 2/200 | 2/200 | 5/200 | | 2/200 | |

As is clear from Tables 4 to 7, when the antenna circuits were laminated on the electromagnetic shield sheets of Examples of the present invention and Comparative Examples to imitate a card or tag with an antenna embedded therein and the laminates were examined for electromagnetic wave transmission characteristics of the antenna, the electromagnetic shield sheets obtained by laminating two polymer composition layers different in conductive material mixing ratio showed a higher reflection-side received power, a lower transmission-side received power and, hence, better results, as compared with the monolayer sheets. Among the conductive materials, the carbons showed better results in regard of the reflection-side received power and transmission-side received power, as compared with metal powders of nickel and the like. The aluminum foil was found to be unsuitable, because of generation of an eddy current. Use of copper meshes in two parallel layers was not so effective as the laminate type of polymer composition layers. In the cases of carbons, more improved results were obtained as the reflection-side received power was increased and the transmission-side received power was decreased in the order of carbon fiber, scaly graphite, and carbon nanotube. Use of carbon nanotube and Ketchen black in mixture led to an increased reflection-side received power, a decreased transmission-side received power and, hence, much improved results. In the cases of the mixture systems of carbon nanotube and Ketchen black, it was found that the electromagnetic shield sheet obtained by laminating two polymer composition layers differing in the mixing ratio (Example 12) showed an enhanced reflection-side received power and a substantially comparable transmission-side received power, notwithstanding the total loading of the carbon nanotube-Ketchen black mixture system was substantially 1/5 times, as compared with the electromagnetic shield sheets having a monolayer of a carbon nanotube-Ketchen black mixture (Comparative Examples 18 and 19). In addition, this electromagnetic shield sheet (Example 12) was found to give much improvement in the reflection-side received power and the transmission-side received power, notwithstanding the total carbon amount was 1/8 times, as compared with the electromagnetic shield sheet obtained by laminating two polymer composition layers using carbon fibers (Example 8). Upon evaluation conducted taking processibility into account, it was found that the electromagnetic shield sheets of Examples 12 and 13 were obtained through extremely smooth kneading of the conductive material into the silicone rubber, whereas the kneading in producing the electromagnetic shield sheets of Comparative Examples 6 to 11 and Examples 8 to 10 did not proceed smoothly. Besides, the electromagnetic shield sheets of Comparative Examples 6 to 9 and Examples 8 and 9 obtained by use of carbon fiber or scaly graphite showed a slightly lowered flexibility of the rubber sheet.

Thus, the electromagnetic shield sheets according to the present invention are efficient even in small electronic circuits, have an electromagnetic shielding effect, and can be utilized for efficient IC tags, labels, readable cards, name plates, etc. in RFID use.

### [Example 14]

An electromagnetic shield sheet was produced in the same manner as in Example 1, except that a urethane rubber was used in place of the silicone rubber of Example 1. The electromagnetic shielding effect owing to the lamination of polymer composition layers different in the loading of the conductive material was developed in the same manner as in Example 1. However, as compared with the sheet using the silicone rubber, this sheet showed a change in the electromagnetic shielding effect when a pressure was exerted thereon, and was thermally deteriorated accompanied by possibility of gas liberation when used for an electronic circuit which generates heat. Besides, the degree of deformation was greater.

### [Example 15]

An electromagnetic shield sheet was produced in the same manner as in Example 1, except that a polyethylene resin was used in place of the silicone rubber of Example 1. The electromagnetic shielding effect owing to the lamination of polymer composition layers differing in the loading of the conductive material was produced in the same manner as in Example 1. As compared with the sheet using the silicone rubber, however, this sheet failed to make close contact with three-dimensional ruggedness of elements when used for an electronic circuit board, resulting in that electromagnetic waves would leak through gaps and that the electromagnetic shielding effect on the circuit as a whole was insufficient. Besides, this sheet was thermally deteriorated and showed a great degree of deformation when applied to an electronic circuit which generates heat.

### [Example 16]

As shown in the sectional view of an IC layout portion in FIG. 7, in place of the laminate b2 of FIG. 4, the electromagnetic shield sheet of Example 12 was formed into a dish-like shape with edges raised along the IC-with-antenna 10 provided in the substrate. Using the electromagnetic shield sheet A3 thus formed, the bottom surface and the end face portions were put into close contact in the form of surrounding the IC-with-antenna 10 so that the periphery of the substrate of the IC-with-antenna 10 was slightly higher than the IC-with-antenna 10, to obtain a laminate b3. The laminate b3 was embedded in a thick plastic (card substrate) 8' having a recess substantially the same in size as the electromagnetic shield sheet A3 formed as above, printable recorded layers 8, 8 were adhered to both sides of the plastic 8', and the assembly was covered with cover layers 9, 9, to produce an IC tag (RFID plate) B3. By this IC tag B3, the directivity in reception/transmission of electromagnetic waves was enhanced.

### Industrial Applicability

The electromagnetic shield sheet according to the present invention is applicable, for example, to use for an electronic circuit board so as to prevent electromagnetic waves generated by electronic component parts themselves in the electronic circuit board from imposing electromagnetic interference on other electronic component parts in the vicinity thereof. Further, the electromagnetic shield sheet of the invention is not only applicable to electronic circuit boards but also applicable in a desired shape such as various shapes of a power supply box, an inner wall or a space in order to prevent electromagnetic interference imposed by strong electromagnetic waves, generated by electric discharge of a power switch or a motor or the like, on other electronic apparatuses. The electromagnetic shield sheet of the invention can also be utilized as an electromagnetic shield sheet capable of shielding electromagnetic waves generated from various electronic apparatuses such as TVs, personal computers, microwave ovens, mobile phones, etc. and capable of preventing external electromagnetic interference from being imposed on these electronic apparatuses. Besides, the electromagnetic shield sheet of the invention can be preferably utilized in the form of an RFID (Radio Frequency Identification) plate capable of coping with downsizing when applied as an IC tag, label, readable card, name plate, or the like which is efficient in reception/transmission of electromagnetic waves, is capable of selecting the shielding direction, and is high in security and in safety for human bodies.

## Claims

1. An electromagnetic shield sheet having a polymer composition layer obtained by mixing a conductive material with a polymer material, said sheet formed by layering at least two said polymer composition layers having different dielectric constants.

2. The electromagnetic shield sheet according to claim 1, containing carbon nanotubes as said conductive material.

3. The electromagnetic shield sheet according to claim 1 or 2, wherein said polymer material is an elastomer.

4. The electromagnetic shield sheet according to claim 1, 2 or 3, wherein said polymer material is a silicone rubber.

5. The electromagnetic shield sheet according to any one of claims 1 to 4, wherein an insulating polymer layer is layered on said polymer composition layers.

6. The electromagnetic shield sheet according to claim 5, wherein said insulating polymer layer contains a magnetic material powder.

7. The electromagnetic shield sheet according to claim 5 or 6, wherein said insulating polymer layer is layered on the side of said polymer composition layer having a lower dielectric constant, of said polymer composition layers.

8. The electromagnetic shield sheet according to any one of claims 1 to 7, having a pressure sensitive adhesive surface.

9. The electromagnetic shield sheet according to any one of claims 5 to 8, wherein said insulating polymer layer has a pressure sensitive adhesive surface.

10. The electromagnetic shield sheet according to any one of claims 1 to 9, comprising at least three said polymer composition layers which are so layered that dielectric constant is increased sequentially.

11. The electromagnetic shield sheet according to any one of claims 1 to 10, wherein at least three said polymer composition layers different in mixing ratio of said conductive material to said polymer material are provided as said polymer composition layers having different dielectric constants, and said at least three polymer composition layers are so layered that said mixing ratio of said conductive material is increased sequentially.

12. The electromagnetic shield sheet according to any one of claims 1 to 11, so used that one of said polymer composition layers which is the lowest of said polymer composition layers in dielectric constant is nearer to an electromagnetic wave generating source.

13. The electromagnetic shield sheet according to any one of claims 1 to 12, so used that one of said polymer composition layers which is the lowest of said polymer composition layers in said mixing ratio of said conductive material is nearer to an electromagnetic wave generating source.

14. An RFID plate comprising a laminate obtained by layering the electromagnetic shield sheet according to any one of claims 1 to 13 as well as an integrated circuit and/or an antenna circuit.

15. The RFID plate according to claim 14, which is a card, a tag, or a label.
